# EUROPEAN PATENT APPLICATION

(11) **EP 4 411 431 A2**
(43) Date of publication of application: **07.08.2024**
(21) Application number: 24152622.7
(22) Date of filing: 18.01.2024
(51) Int. Cl.: G02B 1/14, G02B 27/01, G02F 1/1333, H10K 59/80

(54) **SYSTEMS WITH COVER LAYER SEALING STRUCTURES**

(30) Priority: 02.02.2023 US 202363482957 P; 01.06.2023 US 202363505658 P; 20.12.2023 US 202318391247
(71) Applicant: Apple Inc., Cupertino CA 95014 (US)
(72) Inventor: SINGAMSETTY, Divakar, San Jose (US); OLSON, Jeffrey C., San Francisco (US); LUSSIER, Daniel G., San Francisco (US); FRANKLIN, Jeremy C., San Francisco (US); LYANDRES, Liliya, Sunnyvale (US); MORRIS, Nathan, San Jose (US)
(74) Representative: Froud, Christopher Andrew

(57) **Abstract**

A head-mounted device may have a head-mounted support structure. Rear-facing displays may present images to eye boxes at the rear of the head-mounted support structure. A forward-facing publicly viewable display may be supported on a front side of the head-mounted support structure facing away from the rear-facing displays. The forward-facing display may have pixels that form an active area in which images are displayed and may have a ring-shaped inactive border area that surrounds the pixels. A cover layer may cover the forward-facing display and other optical components. The cover layer may have laminates on front and rear surfaces. To protect an edge surface of the cover layer, encapsulation material may be provided on the edge surface or may otherwise separate the edge surface from an exterior of the device.

## Description

This application claims priority to U.S. patent application No. 18/391,247, filed December 20, 2023, U.S. provisional patent application No. 63/505,658, filed June 1, 2023, and U.S. provisional patent application No. 63/482,957, filed February 2, 2023.

### Field

This relates generally to electronic devices, and, more particularly, to electronic devices such as head-mounted devices.

### Background

Electronic devices such as head-mounted devices may have input-output components. The input-output components may include components such as displays and sensors. The devices may include a cover layer that covers the components.

### Summary

A head-mounted device may have a head-mounted support structure. Rear-facing displays may present images to eye boxes at the rear of the head-mounted support structure. A forward-facing publicly viewable display may be supported on a front side of the head-mounted support structure facing away from the rear-facing displays.

The forward-facing display may have pixels that form an active area in which images are displayed and may have a ring-shaped inactive area that surrounds the pixels. A display cover layer may overlap the active and inactive areas.

Optical components may operate through the cover layer in the inactive area. A cover layer may cover the forward-facing display and other optical components. The cover layer may have laminates on front and rear surfaces. Encapsulation material may be provided on the edge surface or may otherwise separate the edge surface from an exterior of the device.

### Brief Description of the Drawings

FIG. 1 is a side view of an illustrative electronic device such as a head-mounted device in accordance with an embodiment.
FIG. 2 is schematic diagram of an illustrative system with an electronic device in accordance with an embodiment.
FIG. 3 is a front view of an illustrative head-mounted device in accordance with an embodiment.
FIG. 4 is a front view of an illustrative shroud in accordance with an embodiment.
FIG. 5 is a top view of a portion of an illustrative head-mounted device with a display, cover layer, and shroud in accordance with an embodiment.
FIG. 6 is a side view of an illustrative cover layer with encapsulation material that seals an edge surface of the cover layer and overlaps a laminate on the cover layer in accordance with an embodiment.
FIG. 7 is a side view of an illustrative cover layer with encapsulation material that seals an edge surface of the cover layer in accordance with an embodiment.
FIG. 8 is a side view of an illustrative cover layer having an edge surface that is spaced apart from a head-mounted device housing in accordance with an embodiment.
FIG. 9 is a side view of an illustrative cover layer with a bumper ring or overmold structure that seals an edge surface of the cover layer in accordance with an embodiment.
FIG. 10 is a side view of an illustrative cover layer with an upper laminate that wraps an edge surface of the cover layer in accordance with an embodiment.
FIG. 11 is a side view of an illustrative cover layer with a lower laminate that wraps an edge surface of the cover layer in accordance with an embodiment.
FIG. 12 is a side view of an illustrative cover layer and glue that fills a gap between an edge surface of the cover layer and a housing structure in accordance with an embodiment.
FIG. 13 is a side view of an illustrative cover layer with an upper laminate that extends over the cover layer to a housing structure to separate an edge surface of the cover layer from an exterior of the device in accordance with an embodiment.
FIG. 14 is a side view of an illustrative cover layer and a lip formed from a shroud or housing member that overlaps an edge portion of the cover layer in accordance with an embodiment.
FIG. 15 is a side view of an illustrative cover layer and a lip formed from a shroud or housing member that overlaps an edge portion of the cover layer, along with an upper laminate that wraps around the edge portion in accordance with an embodiment.
FIGS. 16 and 17 are side views of illustrative cover layers with upper and lower laminates in accordance with some embodiments.
FIG. 18 is a side view of an illustrative cover layer with a laminate and a seal that covers an edge of the laminate in accordance with some embodiments.

### Detailed Description

A head-mounted device may include a head-mounted support structure that allows the device to be worn on the head of a user. The head-mounted device may have displays that are supported by the head-mounted support structure for presenting a user with visual content. The displays may include rear-facing displays that present images to eye boxes at the rear of the head-mounted support structure. The displays may also include a forward-facing display. The forward-facing display may be mounted to the front of the head-mounted support structure and may be viewed by the user when the head-mounted device is not being worn on the user's head. The forward-facing display, which may sometimes be referred to as a publicly viewable display, may also be viewable by other people in the vicinity of the head-mounted device.

Optical components such as image sensors and other light sensors may be provided in the head-mounted device. In an illustrative configuration, optical components are mounted under peripheral portions of a display cover layer that protects the forward-facing display. The display cover layer, or other layers within the head-mounted device, may be formed from materials, such as glass, and, laminates, such as plastic laminates, may be formed on top and bottom surfaces of the cover layer. To protect the edges of the cover layer, encapsulation material may be coupled to the edge surface, or the head-mounted device housing structures may be modified.

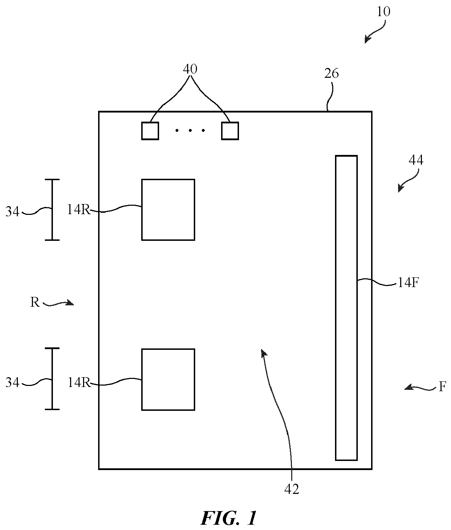

FIG. 1 is a side view of an illustrative head-mounted electronic device. As shown in FIG. 1, head-mounted device 10 may include head-mounted support structure 26. Support structure 26 may have walls or other structures that separate an interior region of device 10 such as interior region 42 from an exterior region surrounding device 10 such as exterior region 44. Electrical components 40 (e.g., integrated circuits, sensors, control circuitry, light-emitting diodes, lasers, and other light-emitting devices, other control circuits and input-output devices, etc.) may be mounted on printed circuits and/or other structures within device 10 (e.g., in interior region 42).

To present a user with images for viewing from eye boxes such as eye boxes 34, device 10 may include rear-facing displays such as displays 14R, which may have associated lenses that focus images for viewing in the eye boxes. These components may be mounted in optical modules (e.g., a lens barrel) to form respective left and right optical systems. There may be, for example, a left rear-facing display for presenting an image through a left lens to a user's left eye in a left eye box and a right rear-facing display for presenting an image to a user's right eye in a right eye box. The user's eyes are located in eye boxes 34 at rear side R of device 10 when structure 26 rests against the outer surface of the user's face.

Support structure 26 may include a main support structure (sometimes referred to as a main portion or housing). The main housing support structure may extend from front side F of device 10 to opposing rear side R of device 10. On rear side R, support structure 26 may have cushioned structures to enhance user comfort as support structure 26 rests against the user's face. If desired, support structure 26 may include optional head straps and/or other structures that allow device 10 to be worn on a head of a user.

Device 10 may have a publicly viewable front-facing display such as display 14F that is mounted on front side F of support structure 26. Display 14F may be viewable to the user when the user is not wearing device 10 and/or may be viewable by others in the vicinity of device 10. Display 14F may, as an example, be visible on front side F of device 10 by an external viewer who is viewing device 10 from front side F.

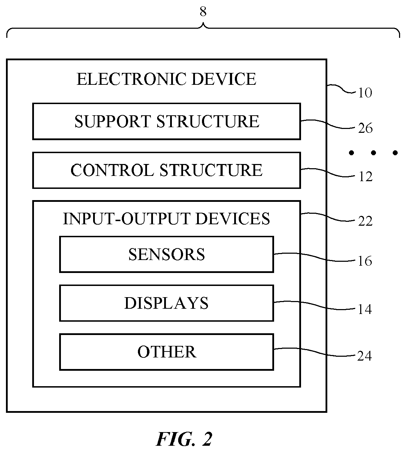

A schematic diagram of an illustrative system that may include a head-mounted device is shown in FIG. 2. As shown in FIG. 2, system 8 may have one or more electronic devices 10. Devices 10 may include a head-mounted device (e.g., device 10 of FIG. 1), accessories such as controllers and headphones, computing equipment (e.g., a cellular telephone, tablet computer, laptop computer, desktop computer, and/or remote computing equipment that supplies content to a head-mounted device), and/or other devices that communicate with each other.

Each electronic device 10 may have control circuitry 12. Control circuitry 12 may include storage and processing circuitry for controlling the operation of device 10. Circuitry 12 may include storage such as hard disk drive storage, nonvolatile memory (e.g., electrically-programmable-read-only memory configured to form a solid-state drive), volatile memory (e.g., static or dynamic random-access-memory), etc. Processing circuitry in control circuitry 12 may be based on one or more microprocessors, microcontrollers, digital signal processors, baseband processors, power management units, audio chips, graphics processing units, application specific integrated circuits, and other integrated circuits. Software code may be stored on storage in circuitry 12 and run on processing circuitry in circuitry 12 to implement control operations for device 10 (e.g., data gathering operations, operations involving the adjustment of the components of device 10 using control signals, etc.). Control circuitry 12 may include wired and wireless communications circuitry. For example, control circuitry 12 may include radio-frequency transceiver circuitry such as cellular telephone transceiver circuitry, wireless local area network transceiver circuitry (e.g., WiFi^{®} circuitry), millimeter wave transceiver circuitry, and/or other wireless communications circuitry.

During operation, the communications circuitry of the devices in system 8 (e.g., the communications circuitry of control circuitry 12 of device 10) may be used to support communication between the electronic devices. For example, one electronic device may transmit video data, audio data, control signals, and/or other data to another electronic device in system 8. Electronic devices in system 8 may use wired and/or wireless communications circuitry to communicate through one or more communications networks (e.g., the internet, local area networks, etc.). The communications circuitry may be used to allow data to be received by device 10 from external equipment (e.g., a tethered computer, a portable device such as a handheld device or laptop computer, online computing equipment such as a remote server or other remote computing equipment, or other electrical equipment) and/or to provide data to external equipment.

Each device 10 in system 8 may include input-output devices 22. Input-output devices 22 may be used to allow a user to provide device 10 with user input. Input-output devices 22 may also be used to gather information on the environment in which device 10 is operating. Output components in devices 22 may allow device 10 to provide a user with output and may be used to communicate with external electrical equipment.

As shown in FIG. 2, input-output devices 22 may include one or more displays such as displays 14. Displays 14 may include rear facing displays such as display 14R of FIG. 1. Device 10 may, for example, include left and right components such as left and right scanning mirror display devices or other image projectors, liquid-crystal-on-silicon display devices, digital mirror devices, or other reflective display devices, left and right display panels based on light-emitting diode pixel arrays (e.g., thin-film organic light-emitting displays with polymer or semiconductor substrates such as silicon substrates or display devices based on pixel arrays formed from crystalline semiconductor light-emitting diode dies), liquid crystal display panels, and/or or other left and right display devices that provide images to left and right eye boxes for viewing by the user's left and right eyes, respectively. Display components such as these (e.g., a thin-film organic light-emitting display with a flexible polymer substrate or a display based on a pixel array formed from crystalline semiconductor light-emitting diode dies on a flexible substrate) may also be used in forming a forward-facing display for device 10 such as forward-facing display 14F of FIG. 1 (sometimes referred to as a front-facing display, front display, or publicly viewable display).

During operation, displays 14 (e.g., displays 14R and/or 14F) may be used to display visual content for a user of device 10 (e.g., still and/or moving images including pictures and pass-through video from camera sensors, text, graphics, movies, games, and/or other visual content). The content that is presented on displays 14 may, for example, include virtual objects and other content that is provided to displays 14 by control circuitry 12. This virtual content may sometimes be referred to as computer-generated content. Computer-generated content may be displayed in the absence of real-world content or may be combined with real-world content. In some configurations, a real-world image may be captured by a camera (e.g., a forward-facing camera, sometimes referred to as a front-facing camera) and computer-generated content may be electronically overlaid on portions of the real-world image (e.g., when device 10 is a pair of virtual reality goggles).

Input-output circuitry 22 may include sensors 16. Sensors 16 may include, for example, three-dimensional sensors (e.g., three-dimensional image sensors such as structured light sensors that emit beams of light and that use two-dimensional digital image sensors to gather image data for three-dimensional images from dots or other light spots that are produced when a target is illuminated by the beams of light, binocular three-dimensional image sensors that gather three-dimensional images using two or more cameras in a binocular imaging arrangement, three-dimensional lidar (light detection and ranging) sensors, sometimes referred to as time-of-flight cameras or three-dimensional time-of-flight cameras, three-dimensional radio-frequency sensors, or other sensors that gather three-dimensional image data), cameras (e.g., two-dimensional infrared and/or visible digital image sensors), gaze tracking sensors (e.g., a gaze tracking system based on an image sensor and, if desired, a light source that emits one or more beams of light that are tracked using the image sensor after reflecting from a user's eyes), touch sensors, capacitive proximity sensors, light-based (optical) proximity sensors, other proximity sensors, force sensors (e.g., strain gauges, capacitive force sensors, resistive force sensors, etc.), sensors such as contact sensors based on switches, gas sensors, pressure sensors, moisture sensors, magnetic sensors, audio sensors (microphones), ambient light sensors, flicker sensors that gather temporal information on ambient lighting conditions such as the presence of a time-varying ambient light intensity associated with artificial lighting, microphones for gathering voice commands and other audio input, sensors that are configured to gather information on motion, position, and/or orientation (e.g., accelerometers, gyroscopes, compasses, and/or inertial measurement units that include all of these sensors or a subset of one or two of these sensors), and/or other sensors.

User input and other information may be gathered using sensors and other input devices in input-output devices 22. If desired, input-output devices 22 may include other devices 24 such as haptic output devices (e.g., vibrating components), light-emitting diodes, lasers, and other light sources (e.g., light-emitting devices that emit light that illuminates the environment surrounding device 10 when ambient light levels are low), speakers such as ear speakers for producing audio output, circuits for receiving wireless power, circuits for transmitting power wirelessly to other devices, batteries and other energy storage devices (e.g., capacitors), joysticks, buttons, and/or other components.

As described in connection with FIG. 1, electronic device 10 may have head-mounted support structures such as head-mounted support structure 26 (e.g., head-mounted housing structures such as housing walls, straps, etc.). The head-mounted support structure may be configured to be worn on a head of a user (e.g., against the user's face covering the user's eyes) during operation of device 10 and may support displays 14, sensors 16, other components 24, other input-output devices 22, and control circuitry 12 (see, e.g., components 40 and displays 14R and 14F of FIG. 1, which may include associated optical modules).

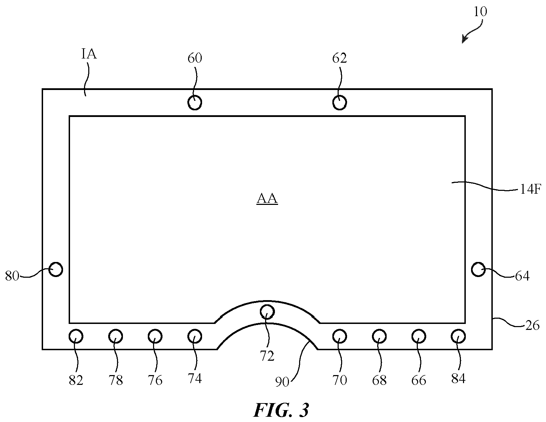

FIG. 3 is a front view of device 10 in an illustrative configuration in which device 10 has a publicly viewable display such as forward-facing display 14F. As shown in FIG. 3, support structure 26 of device 10 may have right and left portions on either side of nose bridge 90. Nose bridge 90 may be a curved exterior surface that is configured to receive and rest upon a user's nose to help support housing 26 on the head of the user.

Display 14F may have an active area such as active area AA that is configured to display images and an inactive area IA that does not display images. The outline of active area AA may be rectangular, rectangular with rounded corners, may have teardrop shaped portions on the left and right sides of device 10, may have a shape with straight edges, a shape with curved edges, a shape with a peripheral edge that has both straight and curved portions, and/or other suitable outlines. As shown in FIG. 3, active area AA may have a curved recessed portion at nose bridge 90. The presence of the nose-shaped recess in active area AA may help fit active area AA within the available space of housing 26 without overly limiting the size of active area AA.

Active area AA contains an array of pixels. The pixels may be, for example, light-emitting diode pixels formed from thin-film organic light-emitting diodes or crystalline semiconductor light-emitting diode dies (sometimes referred to as micro-light-emitting diodes) on a flexible display panel substrate. Configurations in which display 14F uses other display technologies may also be used, if desired. Illustrative arrangements in which display 14 is formed from a light-emitting diode display such as an organic light-emitting diode display that is formed on a flexible substrate (e.g., a substrate formed from a bendable layer of polyimide or a sheet of other flexible polymer) may sometimes be described herein as an example. The pixels of active area AA may be formed on a display device such as a display panel (e.g., a flexible organic light-emitting diode display panel). In some configurations, the outline of active area AA may have a peripheral edge that contains straight segments or a combination of straight and curved segments. Configurations in which the entire outline of active area AA is characterized by a curved peripheral edge may also be used.

Display 14F may have an inactive area such as inactive area IA that is free of pixels and that does not display images. Inactive area IA may form an inactive border region that runs along one more portions of the peripheral edge of active area AA. In the illustrative configuration of FIG. 3, inactive area IA has a ring shape that surrounds active area AA and forms an inactive border. In this type of arrangement, the width of inactive area IA may be relatively constant and the inner and outer edges of area IA may be characterized by straight and/or curved segments or may be curved along their entire lengths. For example, the outer edge of area IA (e.g., the periphery of display 14F) may have a curved outline that runs parallel to the curved edge of active area AA.

In some configurations, device 10 may operate with other devices in system 8 (e.g., wireless controllers and other accessories). These accessories may have magnetic sensors that sense the direction and intensity of magnetic fields. Device 10 may have one or more electromagnets configured to emit a magnetic field. The magnetic field can be measured by the wireless accessories near device 10, so that the accessories can determine their orientation and position relative to device 10. This allows the accessories to wirelessly provide device 10 with real-time information on their current position, orientation, and movement so that the accessories can serve as wireless controllers. The accessories may include wearable devices, handled devices, and other input devices.

In an illustrative configuration, device 10 may have a coil that runs around the perimeter of display 14F (e.g., under inactive area IA along the periphery of active area AA). The coil may have any suitable number of turns (e.g., 1-10, at least 2, at least 5, at least 10, 10-50, fewer than 100, fewer than 25, fewer than 6, etc.). These turns may be formed from metal traces on a substrate, may be formed from wire, and/or may be formed from other conductive lines. During operation, control circuitry 12 may supply the coil with an alternating-current (AC) drive signal. The drive signal may have a frequency of at least 1 kHz, at least 10 kHz, at least 100 kHz, at least 1 MHz, less than 10 MHz, less than 3 MHz, less than 300 kHz, or less than 30 kHz (as examples). As AC current flows through the coil a corresponding magnetic field is produced in the vicinity of device 10. Electronic devices such as wireless controllers with magnetic sensors that are in the vicinity of device 10 may use the magnetic field as a reference so that the wireless controllers can determine their orientation, position, and/or movement while being moved relative to device 10 to provide device 10 with input.

Consider, as an example, a handheld wireless controller that is used in controlling the operation of device 10. During operation, device 10 uses the coil to emit a magnetic field. As the handheld wireless controller is moved, the magnetic sensors of the controller can monitor the location of the controller and the movement of the controller relative to device 10 by monitoring the strength, orientation, and change to the strength and/or orientation of the magnetic field emitted by the coil as the controller is moved through the air by the user. The electronic device can then wirelessly transmit information on the location and orientation of the controller to device 10. In this way, a handheld controller, wearable controller, or other external accessory can be manipulated by a user to provide device 10 with air gestures, pointing input, steering input, and/or other user input.

Device 10 may have components such as optical components (e.g., optical sensors among sensors 16 of FIG. 2). These components may be mounted in any suitable location on head-mounted support structure 26 (e.g. on a head strap, on housing 26, etc.). Optical components and other components may face rearwardly (e.g., when mounted on the rear face of device 10), may face to the side (e.g. to the left or right), may face downwardly or upwardly, may face to the front of device 10 (e.g., when mounted on the front face of device 10), may be mounted so as to point in any combination of these directions (e.g., to the front, to the right, and downward) and/or may be mounted in other suitable orientations. In an illustrative configuration, at least some of the components of device 10 are mounted so as to face outwardly to the front (and optionally to the sides and/or up and down). For example, forward-facing cameras for pass-through video may be mounted on the left and right sides of the front of device 10 in a configuration in which the cameras diverge slightly along the horizontal dimension so that the fields of view of these cameras overlap somewhat while capturing a wide-angle image of the environment in front of device 10. The captured image may, if desired, include portions of the user's surroundings that are below, above, and to the sides of the area directly in front of device 10.

To help hide components such as optical components from view from the exterior of device 10, it may be desirable to cover some or all of the components with cosmetic covering structures. The covering structures may include transparent portions (e.g., optical component windows) that are characterized by sufficient optical transparency to allow overlapped optical components to operate satisfactorily. For example, an ambient light sensor may be covered with a layer that appears opaque to an external viewer to help hide the ambient light sensor from view, but that allows sufficient ambient light to pass to the ambient light sensor for the ambient light sensor to make a satisfactory ambient light measurement. As another example, an optical component that emits infrared light may be overlapped with a visibly opaque material that is transparent to infrared light.

In an illustrative configuration, optical components for device 10 may be mounted in inactive area IA of FIG. 3 and cosmetic covering structures may be formed in a ring shape overlapping the optical components in inactive area IA. Cosmetic covering structures may be formed from ink, polymer structures, structures that include metal, glass, other materials, and/or combinations of these materials. In an illustrative configuration, a cosmetic covering structure may be formed from a ring-shaped member having a footprint that matches the footprint of inactive area IA. If, for example, active area AA has left and right portions with teardrop shapes, the ring-shaped member may have curved edges that follow the curved periphery of the teardrop-shaped portions of active area AA. The ring-shaped member may be formed from one or more polymer structures (e.g., the ring-shaped member may be formed from a polymer ring). Because the ring-shaped member can help hide overlapped components from view, the ring-shaped member may sometimes be referred to as a shroud or ring-shaped shroud member. The outward appearance of the shroud or other cosmetic covering structures may be characterized by a neutral color (white, black, or gray) or a non-neutral color (e.g., blue, red, green, gold, rose gold, etc.).

Display 14F may, if desired, have a protective display cover layer. The cover layer may overlap active area AA and inactive area IA (e.g., the entire front surface of device 10 as viewed from front F of FIG. 1 may be covered by the cover layer). The cover layer, which may sometimes be referred to as a housing wall or transparent housing wall, may have a rectangular outline, an outline with teardrop portions, an oval outline, or other shape with curved and/or straight edges.

The cover layer may be formed from a transparent material such as glass, polymer, transparent crystalline material such as sapphire, clear ceramic, other transparent materials, and/or combinations of these materials. As an example, a protective display cover layer for display 14F may be formed from safety glass (e.g., laminated glass that includes a clear glass layer with a laminated polymer film). Optional coating layers may be applied to the surfaces of the display cover layer. If desired, the display cover layer may be chemically strengthened (e.g., using an ion-exchange process to create an outer layer of material under compressive stress that resists scratching). In some configurations, the display cover layer may be formed from a stack of two or more layers of material (e.g., first and second structural glass layers, a rigid polymer layer coupled to a glass layer or another rigid polymer layer, etc.) to enhance the performance of the cover layer.

In active area AA, the display cover layer may overlap the pixels of display panel 14P. The display cover layer in active area AA is preferably transparent to allow viewing of images presented on display panel 14P. In inactive area IA, the display cover layer may overlap the ring-shaped shroud or other cosmetic covering structure. The shroud and/or other covering structures (e.g., opaque ink coatings on the inner surface of the display cover layer and/or structures) may be sufficiently opaque to help hide some or all of the optical components in inactive area IA from view. Windows may be provided in the shroud or other cosmetic covering structures to help ensure that the optical components that are overlapped by these structures operate satisfactorily. Windows may be formed from holes, may be formed from areas of the shroud or other cosmetic covering structures that have been locally thinned to enhance light transmission, may be formed from window members with desired light transmission properties that have been inserted into mating openings in the shroud, and/or may be formed from other shroud window structures.

In the example of FIG. 3, device 10 includes optical components such as optical components 60, 62, 64, 66, 68, 70, 72, 74, 76, 78, and 80 (as an example). Each of these optical components (e.g., optical sensors selected from among sensors 16 of FIG. 2, light-emitting devices, etc.) may be configured to detect light and, if desired to emit light (e.g., ultraviolet light, visible light, and/or infrared light).

In an illustrative configuration, optical component 60 may sense ambient light (e.g., visible ambient light). In particular, optical component 60 may have a photodetector that senses variations in ambient light intensity as a function of time. If, as an example, a user is operating in an environment with an artificial light source, the light source may emit light at a frequency associated with its source of wall power (e.g., alternating-current mains power at 60 Hz). The photodetector of component 60 may sense that the artificial light from the artificial light source is characterized by 60 Hz fluctuations in intensity. Control circuitry 12 can use this information to adjust a clock or other timing signal associated with the operation of image sensors in device 10 to help avoid undesired interference between the light source frequency and the frame rate or other frequency associated with image capture operations. Control circuitry 12 can also use measurements from component 60 to help identify the presence of artificial lighting and the type of artificial lighting that is present. In this way, control circuitry 12 can detect the presence of lights such as fluorescent lights or other lights with known non-ideal color characteristics and can make compensating color cast adjustments (e.g., white point adjustments) to color-sensitive components such as cameras and displays. Because optical component 60 may measure fluctuations in light intensity, component 60 may sometimes be referred to as a flicker sensor or ambient light frequency sensor.

Optical component 62 may be an ambient light sensor. The ambient light sensor may include one or more photodetectors. In a single-photodetector configuration, the ambient light sensor may be a monochrome sensor that measures ambient light intensity. In a multi-photodetector configuration, each photodetector may be overlapped by an optical filter that passes a different band of wavelengths (e.g. different visible and/or infrared passbands). The optical filter passbands may overlap at their edges. This allows component 62 to serve as a color ambient light sensor that measures both ambient light intensity and ambient light color (e.g., by measuring color coordinates for the ambient light). During operation of device 10, control circuitry 12 can take action based on measured ambient light intensity and color. As an example, the white point of a display or image sensor may be adjusted or other display or image sensor color adjustments may be made based on measured ambient light color. The intensity of a display may be adjusted based on light intensity. For example, the brightness of display 14F may be increased in bright ambient lighting conditions to enhance the visibility of the image on the display and the brightness of display 14F may be decreased in dim lighting conditions to conserve power. Image sensor operations and/or light source operations may also be adjusted based on ambient light readings.

The optical components in active area IA may also include components along the sides of device 10 such as components 80 and 64. Optical components 80 and 64 may be pose-tracking cameras that are used to help monitor the orientation and movement of device 10. Components 80 and 64 may be visible light cameras (and/or cameras that are sensitive at visible and infrared wavelengths) and may, in conjunction with an inertial measurement unit, form a visual inertial odometry (VIO) system.

Optical components 78 and 66 may be visible-light cameras that capture real-time images of the environment surrounding device 10. These cameras, which may sometimes be referred to as scene cameras or pass-through-video cameras, may capture moving images that are displayed in real time to displays 14R for viewing by the user when the user's eyes are located in eye boxes 34 at the rear of device 10. By displaying pass-through images (pass-through video) to the user in this way, the user may be provided with real-time information on the user's surroundings. If desired, virtual content (e.g. computer-generated images) may be overlaid over some of the pass-through video. Device 10 may also operate in a non-pass-through-video mode in which components 78 and 66 are turned off and the user is provided only with movie content, game content, and/or other virtual content that does not contain real-time real-world images.

Input-output devices 22 of device 10 may gather user input that is used in controlling the operation of device 10. As an example, a microphone in device 10 may gather voice commands. Buttons, touch sensors, force sensors, and other input devices may gather user input from a user's finger or other external object that is contacting device 10. In some configurations, it may be desirable to monitor a user's hand gestures or the motion of other user body parts. This allows the user's hand locations or other body part locations to be replicated in a game or other virtual environment and allows the user's hand motions to serve as hand gestures (air gestures) that control the operation of device 10. User input such as hand gesture input can be captured using cameras that operate at visible and infrared wavelengths such as tracking cameras (e.g., optical components 76 and 68). Tracking cameras such as these may also track fiducials and other recognizable features on controllers and other external accessories (additional devices 10 of system 8) during use of these controllers in controlling the operation of device 10. If desired, tracking cameras can help determine the position and orientation of a handheld controller or wearable controller that senses its location and orientation by measuring the magnetic field produced by coil 54. The use of tracking cameras may therefore help track hand motions and controller motions that are used in moving pointers and other virtual objects being displayed for a user and can otherwise assist in controlling the operation of device 10.

Tracking cameras may operate satisfactorily in the presence of sufficient ambient light (e.g., bright visible ambient lighting conditions). In dim environments, supplemental illumination may be provided by supplemental light sources such as supplemental infrared light sources (e.g., optical components 82 and 84). The infrared light sources may each include one or more light-emitting devices (light-emitting diodes or lasers) and may each be configured to provide fixed and/or steerable beams of infrared light that serve as supplemental illumination for the tracking cameras. If desired, the infrared light sources may be turned off in bright ambient lighting conditions and may be turned on in response to detection of dim ambient lighting (e.g., using the ambient light sensing capabilities of optical component 62).

Three-dimensional sensors in device 10 may be used to perform biometric identification operations (e.g., facial identification for authentication), may be used to determine the three-dimensional shapes of objects in the user's environment (e.g., to map the user's environment so that a matching virtual environment can be created for the user), and/or to otherwise gather three-dimensional content during operation of device 10. As an example, optical components 74 and 70 may be three-dimensional structured light image sensors. Each three-dimensional structured light image sensor may have one or more light sources that provide structured light (e.g., a dot projector that projects an array of infrared dots onto the environment, a structured light source that produces a grid of lines, or other structured light component that emits structured light). Each of the three-dimensional structured light image sensors may also include a flood illuminator (e.g., a light-emitting diode or laser that emits a wide beam of infrared light). Using flood illumination and structured light illumination, optical components 74 and 70 may capture facial images, images of objects in the environment surrounding device 10, etc.

Optical component 72 may be an infrared three-dimensional time-of-flight camera that uses time-of-flight measurements on emitted light to gather three-dimensional images of objects in the environment surrounding device 10. Component 72 may have a longer range and a narrower field of view than the three-dimensional structured light cameras of optical components 74 and 70. The operating range of component 72 may be 30 cm to 7 m, 60 cm to 6 m, 70 cm to 5 m, or other suitable operating range (as examples).

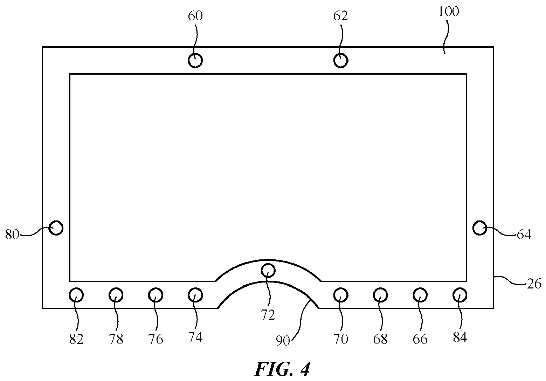

FIG. 4 is a front view of an illustrative ring-shaped cosmetic covering structure for device 10. Illustrative ring-shaped shroud 100 of FIG. 4 may be mounted under the inner surface of the display cover layer for display 14F in inactive area IA. This may help hide the optical components and other internal portions of device 10 from view from the exterior of device 10. Shroud 100 may be formed from one or more unbroken ring-shaped members and/or may be formed from multiple shroud segments that are attached using adhesive, fasteners, or other attachment structures. If desired, shroud 100 may be formed from multiple members that are sandwiched together along some or all of their lengths. In an illustrative configuration, which may sometimes be described herein as an example, shroud 100 may be formed from an inner piece (e.g., an inner full or partial ring), which may sometimes be referred to as an inner shroud member, shroud trim, or shroud trim member and may be formed from an outer piece or pieces (e.g., one or more strips of material or covering members, an full ring, one or more partial rings, etc.), which may sometimes be referred to as a shroud cover, canopy, or shroud canopy.

As shown in FIG. 4, shroud 100 may have optical component windows to accommodate components 60, 62, 64, 84, 66, 68, 70, 72, 74, 76, 78, 82, and 80. The optical component windows may be formed from through-hole openings in shroud 100, from recesses or other partial openings that do not pass entirely through shroud 100, from inserted optical window members in shroud through-hole openings, and/or from other shroud optical component window structures. Display 14F may have a display cover layer that has corresponding optical component windows (through-hole openings, recessed areas, inserted window members in through-hole openings, etc.) and/or that is formed from bulk material that has desired optical properties (e.g., a display cover layer formed from one or more layers of material such as glass and/or polymer with sufficient transparency at the operating wavelength range of the overlapped optical component to allow the optical component to operate satisfactorily through the cover layer without forming openings or other window structures in the cover layer).

Shroud 100 may have any suitable shape. For example, the outline of shroud 100 may be rectangular with rounded corners as shown in FIG. 4, may have teardrop shapes on the left and right sides of device 10, may have an oval outline, and/or may have other outlines with curved and/or straight edge segments. For example, the inner and outer edges of shroud 100 may be curved (e.g., to follow a teardrop shape). Shroud 100 may, if desired, have a peripheral edge that is curved along most or all of its length.

The width of shroud 100 may be constant along its length or shroud 100 may have portions that are wider than others. The thickness of shroud 100 (e.g., the dimension of shroud 100 into the page in the orientation of FIG. 4) may be smaller than the width of shroud 100 (the lateral dimension of shroud 100 within the page in the orientation of FIG. 4) or the thickness of the shroud may be equal to or greater than the width of the shroud. The shroud may have a two-dimensional shape (e.g., shroud 100 may have a planar shape) or may have a three-dimensional shape (e.g., a shape with a curved cross-sectional profile and/or a shape characterized by inner and/or outer surfaces of compound curvature). In an illustrative configuration, most or all of the inner and outer surfaces of shroud have a compound-curvature surface.

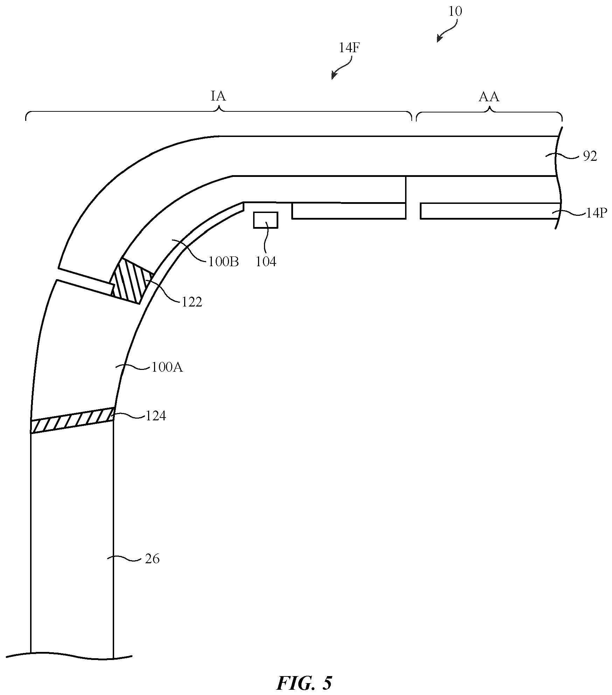

The optical components under inactive area IA may include components on the left and right sides of device 10 that operate in conjunction with each other. for example, scene cameras, tracking cameras, and/or structured light cameras in device 10 may be formed in pairs, each of which includes a left camera and a corresponding right camera. A left scene camera and a right scene camera may, as an example, operate together to capture overlapping images that provide device 10 with a wide field of view for gathering pass-through video. Left and right tracking cameras may operate together to track a user's hands or other external objects. Left and right structured light cameras or other three-dimensional cameras may be used together to capture three-dimensional images of the user's environment. To enhance performance of the left and right optical components in these types of paired component arrangements, it may be desirable to maintain accurate alignment between the left and right optical components. To help maintain left and right optical components on the respective left and right sides of device 10 in alignment with each other, device 10 may be provided with one or more housing structures that help support the optical components. An illustrative example of device 10 having housing structures that support the optical components and a cover layer that overlaps the optical components is shown in FIG. 5.

As shown in FIG. 5, shroud 100 and display cover layer 92 may be attached to housing 26 using adhesive, screws and other fasteners, press-fit connections, and/or other attachment mechanisms. An illustrative configuration in which shroud 100 and cover layer 92 are attached to forward-facing edge of a housing wall in the main housing portion of structure 26 using adhesive is shown in FIG. 5. In the example of FIG. 5, shroud 100 has an inner shroud member such as shroud trim 100A and has a corresponding outer shroud member such as shroud canopy 100B. Shroud trim 100A and shroud canopy 100B may be formed from metal, polymer, ceramic, glass, other materials, and/or combinations of these materials. In an illustrative example, shroud trim 100A is formed from black polymer or other dark material and shroud canopy 100B is formed from clear polymer. The outer surface of shroud canopy 100B may be smooth to provide shroud 100 with a cosmetically attractive appearance.

A layer of pressure sensitive adhesive may be used in attaching canopy 100B to trim 100A, or canopy 100B may be formed integrally with trim 100A. Adhesive may also be used in attaching cover layer 92 and shroud 100 to housing portion 26. As shown in FIG. 5, for example, a first adhesive such as adhesive 122 may be used to attach display cover layer 92 to shroud 100 (e.g., to a ledge in shroud trim 100A). A second adhesive such as adhesive 124 may, in turn, be used to attach shroud 100 (e.g., shroud trim 100A) to an adjacent lip of a wall in housing 26.

In some configurations, adhesives 122 and 124 may be formed from the same type of material. In an illustrative configuration, adhesives 122 and 124 are different. Housing portion 26 may have a wall with a lip shape that creates a shearing force on adhesive 124 as display 14F is attached to housing 26 by pressing display 14F against housing 26. In this type of scenario, it may be desirable to form adhesive 124 from an adhesive that can bond satisfactorily in the presence of shear forces such as a molten hot melt glue (thermoplastic adhesive) or other liquid adhesive rather than pressure sensitive adhesive. Adhesive 124 may, if desired, be exposed to a curing agent (ultraviolet light, moisture, etc.) before display 14F is assembled into housing 26.

Adhesive 124 may be heated to loosen the adhesive bond formed by adhesive 124, if desired. To help prevent display cover layer 92 from detaching from shroud 100 while softening adhesive 124 with heat, adhesive 122 may be provided with a higher- temperature softening point than adhesive 124 (e.g., adhesive 122 may be a two-part hot melt glue with a higher melting point than adhesive 124).

Optical components that are overlapped by display cover layer 92 and shroud 100 in inactive area IA may transmit and/or receive light through shroud 100 and display cover layer 92. Layer 92 may be formed from a single layer of glass, laminated glass, or other clear material that allows light for each overlapped optical component 104 to pass through layer 92. If desired, a partial recess or a through-hole opening may be formed in the portion of layer 92. An optional optical component window member may then be inserted within layer 92 (e.g., a window that overlaps component 104). As an example, layer 92 may be formed from one or more layers of glass and/or polymer and may be characterized by a first level of light transmission at operating wavelength(s) for component 104. A window member in layer 92 may be formed from polymer, glass, and/or other materials that are characterized by a second level of light transmission at the operating wavelength(s) that is greater than the first level of light transmission. In other illustrative arrangements, no window member is inserted in layer 92 (e.g., when layer 92 alone is sufficiently transparent to pass light for component 104).

Shroud 100 may be provided with an optical component window that overlaps optical component to help accommodate overlapped optical component 104. Component 104 may operate at ultraviolet light wavelengths, visible light wavelengths, and/or infrared light wavelengths. To accommodate component 104, shroud trim 100A has been provided with a through-hole opening, whereas shroud canopy 100B has no openings overlapping component 104. This effectively forms a window recess in shroud 100 in alignment with components 104. Trim 100A may be formed from black polymer or other light-absorbing material, so the formation of opening 120 in trim 100A may help ensure that sufficiently light may pass through to allow component 104 to operate satisfactorily. The portion of canopy 100B that overlaps component 104 may be transparent (e.g., clear polymer). Alternatively, canopy 100B may be formed from light-absorbing material, and a portion of canopy 100B overlapping component 104 may be removed.

To help hide component 104 from view, the inner surface of shroud canopy 100B may be covered with one or more coatings, which may be used to provide region the region overlapping component 104 with a desired outward appearance and optical properties that ensure that component 104 can operate satisfactorily. The coatings may include a thin-film-interference filter formed from a stack of thin-film dielectric layers of alternating refractive index values (with indices and thicknesses selected to create a desired transmission spectrum and a desired reflection spectrum for the filter), may include a layer of ink (e.g., a polymer layer including dye, pigment, and/or other colorant), and/or may include any other suitable coating with desired optical properties.

Consider, as an example, a scenario in which component 104 transmits and/or receives infrared light. In this type of arrangement, canopy 100B may be coated with a coating that is opaque at visible wavelengths and transparent at infrared wavelengths. This helps to hide component 104 from view from the exterior of device 10 while allowing infrared light associated with the operation of component 104 to pass through shroud 100 and layer 92.

As another example, consider a scenario in which component 104 is an ambient light sensor. In this configuration, canopy 100B may be coated with a coating that exhibits a visible light transmission of 1-8% (as an example). This may allow sufficient visible ambient light to reach the ambient light sensor for the ambient light sensor to make an ambient light reading. At the same time, the transmission of the coating may be sufficiently low to reduce the visibility of component 104 from the exterior of device 10.

As these examples demonstrate, regions of display 14F that overlap optical components such as component 104 of FIG. 5 may be provided with optical component window structures in layer 92 and/or shroud 100 that help accommodate the optical component.

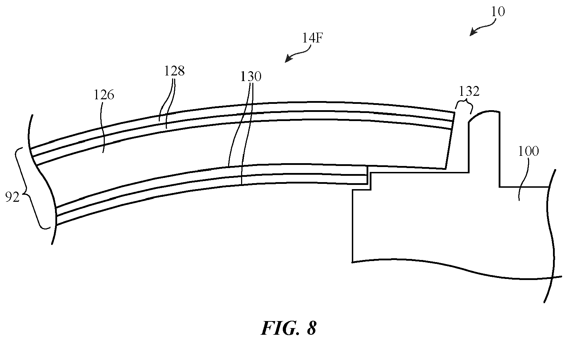

As described in connection with FIGS. 3 and 4, there may be numerous optical components such as component 104 in inactive area IA. Each optical component may potentially have a different type of optical component window structure in shroud 100 and/or layer 92 to accommodate that component. For example, some areas of shroud 100 may have openings that receive components, other areas of shroud 100 may have inserted optical window member, and/or other areas of shroud 100 may have partial shroud openings (e.g., non-through-hole recesses) such as the opening of FIG. 8 (which may optionally be coated to modify the optical properties of shroud 100).

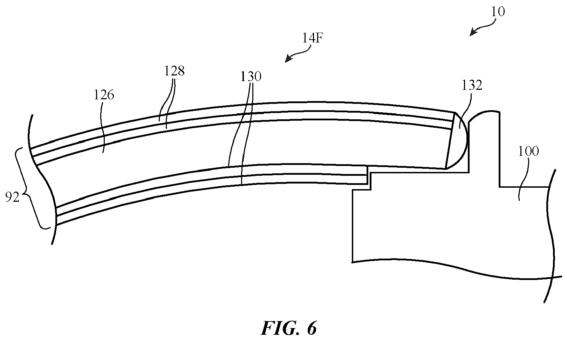

In some embodiments, it may be desirable to provide encapsulation material over cover layer 92. An illustrative example of cover layer 92 with encapsulation is shown in FIG. 6.

As shown in FIG. 6, cover layer 92 may be coupled to shroud 100. Cover layer 92 may include glass layer 126, front laminate 128 and rear laminate 130. Front laminate 128 and rear laminate 128 may be for example, layers of plastic that are laminated to cover layer 92, layers of plastic that are adhesively attached to cover layer 92, or other protective material that is attached to the front and rear surfaces of glass layer 126. Although not shown in FIG. 6, multiple layers, such as antireflection coatings, antismudge coatings, acrylic layers, or other desired layers, may be included as part of cover layer 92.

Although front laminate 128 and rear laminate 130 may protect the front and rear of glass layer 126, an edge surface of glass layer 126 may still be exposed. To further protect the edge surface of glass layer 126, encapsulation material 132 may be attached to the edge surface of glass layer 126. Encapsulation material 132 may be an epoxy material, such as a ductile epoxy, that seals the edge surface of glass layer 126 and protects glass layer 126 at the edge surface. Alternatively, acrylate, polyvinyl butyral (PVB), polyurethane, or moisture cure materials may be used for encapsulation material 132.

In some embodiments, encapsulation material 132 may be an epoxy that adheres to glass layer 126 without a primer (e.g., encapsulation material 132 may be a primer-less adhesive). Moreover, encapsulation material 132 may have adequate ductility to elongate and not fracture, such as a Young's modulus of less than 3 GPa, less than 4 GPa, less than 2.5 GPa, or other suitable modulus. Additionally, encapsulation material 132 may be chemically resistant to chemicals and resistant to degradation due to solar exposure. It may also be desirable for encapsulation material 132 to match an appearance of the shroud. For example, encapsulation material 132 may have a black appearance, a white appearance, a gray appearance, a shiny appearance, and/or a matte appearance. In general, encapsulation material 132 may be formed from material that adheres to glass layer 126, while protecting the edge surface of glass layer 126.

Encapsulation material 132 may substantially fill the opening between the edge surface of glass layer 126 and shroud 100. For example, encapsulation material 132 may extend approximately 150 microns from the edge surface. In general, however, any amount of encapsulation material 132 may be applied to the edge surface.

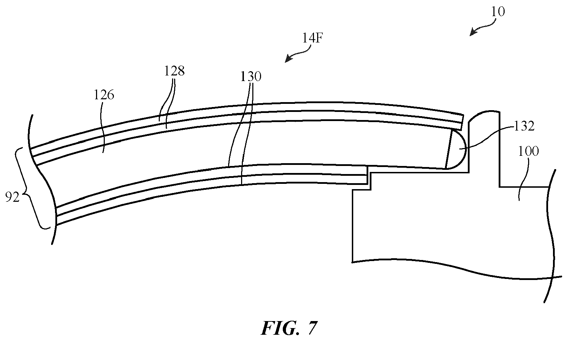

As shown in Fig. 6, encapsulation material 132 may cover the edge surface and may also cover an edge portion of laminate 128. However, this is merely illustrative. If desired, encapsulation material 132 may cover the edge surface of glass layer 126 without covering an edge portion of laminate 128. For example, as shown in FIG. 7, encapsulation material may cover only the edge surface of glass layer 126. In the example of FIG. 7, laminate 128 may extend over encapsulation material 132. However, this is merely illustrative. Laminate 128 may be flush with the edge surface of glass layer 126, if desired.

In some embodiments, it may be determined that glass layer 126 can be protected by modifying the position of glass layer 126 relative to shroud 100 (or support structure 126). For example, as shown in the illustrative embodiment of FIG. 8, the edge surface of glass layer 126 may be left unencapsulated, but the size of opening 134 between the edge surface and shroud 100 may be adjusted. By increasing or decreasing the size of opening 134, glass layer 126 may be protected.

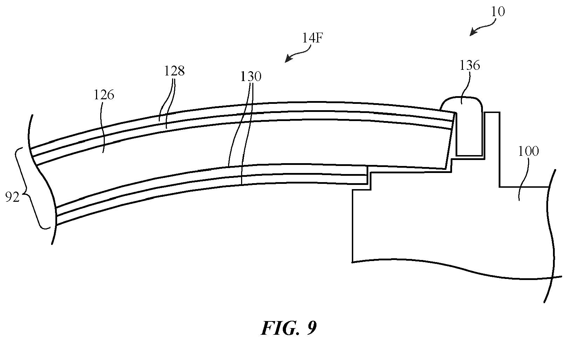

Instead of, or in addition to, adding material to the edge surface of layer 126, it may be desirable to add material in the gap between layer 126 and the shroud/support structure. An illustrative example of adding material in this gap is shown in FIG. 9.

As shown in FIG. 9, material 136 may be included between the edge surface of glass layer 126 and shroud 100. Material 136 may be, for example, a bumper ring. The bumper ring may be formed from elastomer, rigid plastic, or another material that helps protect the edge surface of layer 126.

As an alternative to material 136 being a bumper ring between layer 126 and shroud 100, material 136 may be an overmolded structure on layer 126, on shroud 100, or on a chassis that is coupled to support structure 26. In general, the overmolded structure may fill the gap between layer 126 and the support structure, shroud, and/or chassis and help protect the edge surface of layer 126.

Although not shown in FIG. 9, a portion of material 136 may extend underneath layer 126 if desired. In particular, there may be a portion of material 136 between the bottom surface of layer 126 and shroud 100.

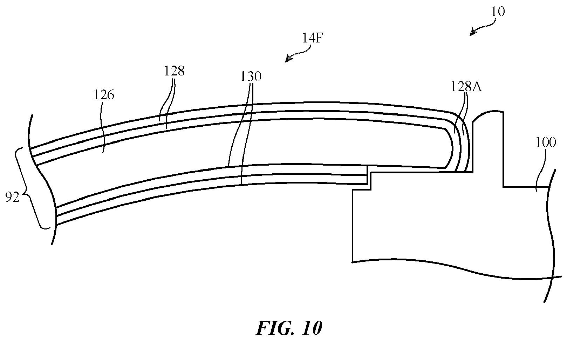

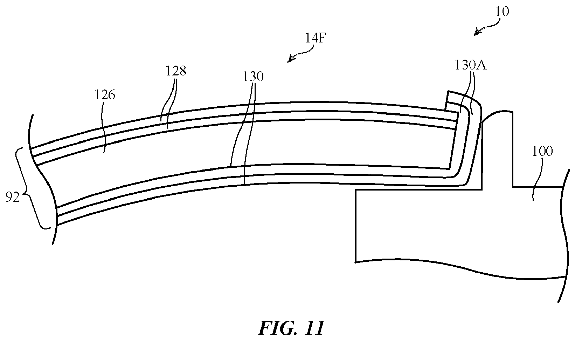

Instead of, or in addition to, adding material between layer 126 and shroud 100, upper laminate 128 and/or lower laminate 130 may wrap around the edge surface of layer 126. Illustrative examples of the laminates wrapping the edge surface are shown in FIGS. 10 and 11.

As shown in FIG. 10, upper laminate 128 may wrap around the edge surface of layer 126. In particular, upper laminate 128 may have portion 128A that extends around and covers the edge surface of layer 126. Layer 126 may have a rounded edge surface to allow upper laminate 128 to wrap the edge surface and sufficiently adhere to the surface, as shown in FIG. 10. By forming layer 126 with a rounded edge, the curve of laminate 128 around the edge may be reduced, thereby reducing stress on laminate 128. However, layer 126 may have a planar edge surface, or a surface with any other desired profile, around which upper laminate 128 wraps, if desired. By wrapping upper laminate around the edge surface of layer 126, the edge surface may be protected

As shown in FIG. 11, lower laminate 130 may wrap around the edge surface of layer 126. In particular, lower laminate may have portion 130A that extends around and covers the edge surface of layer 126. Layer 126 may have a rounded edge surface to allow lower laminate 130 to wrap the edge surface and sufficiently adhere to the surface, may have a planar edge surface, or may have a surface with any other desired profile, around which lower laminate 130 wraps. By wrapping lower laminate 130 around the edge surface of layer 126, the edge surface may be protected.

In the example of FIG. 11, lower laminate portion 130A wraps entirely around the edge surface of layer 126 and partially overlaps upper laminate 128. However, the arrangement is merely illustrative. If desired, lower laminate portion 130A may wrap around only the edge surface of layer 126 without overlapping or extending over upper laminate 128.

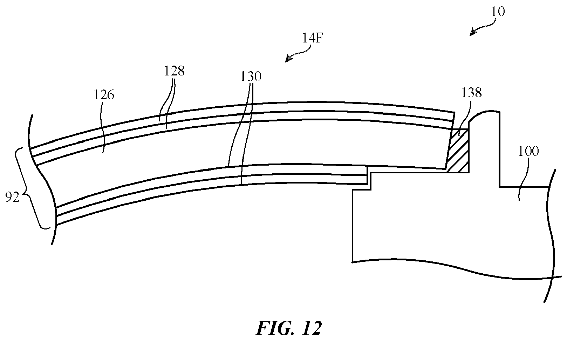

Another example of material that may be used to protect layer 126 is shown in FIG. 12. In the example of FIG. 12, glue (or another similar material) 138 may be used to completely fill the gap between layer 126 and shroud 100. For example, the glue may be inserted into the gap after cover layer 92 has been assembled into the head-mounted device. Glue 138 may help protect the edge surface of layer 126.

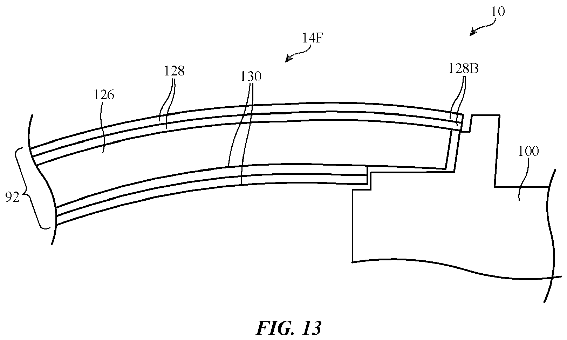

Rather than wrapping the upper or lower laminate around the edge surface of layer 126, upper laminate 128 may extend to shroud 100 to cover the gap between the edge surface and shroud 100. For example, as shown in FIG. 13, upper laminate 128 may have portion 128B that extends to shroud 100 (or support structure 26 or another portion of device 10). By covering the gap between the edge surface of layer 126 and shroud 100, the edge surface may be protected.

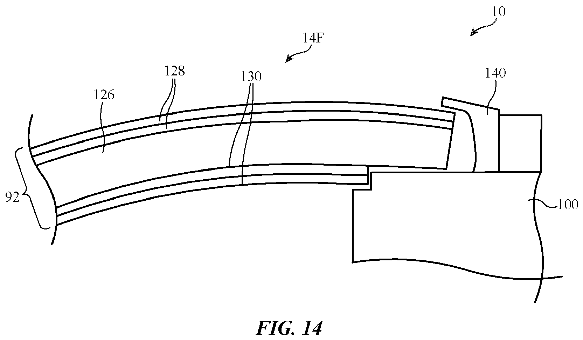

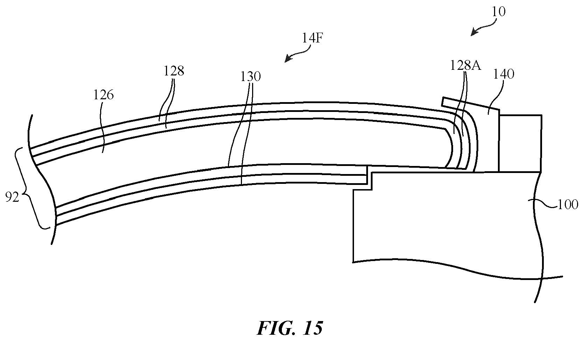

Instead of, or in addition to, adding material or extending the laminates to protect the edge surface of layer 126, shroud 100 or a chassis attached to support structure 26 may be modified to protect the edge surface. Illustrative examples of modifying these components to protect layer 126 are shown in FIGS. 14 and 15.

As shown in FIG. 14, structure 140 may have a lip that covers the gap between layer 126 and shroud 100/support structure 26. Structure 140 may be formed from a portion of shroud 100 or from a portion of support structure 26 (e.g., a chassis of support structure 26). The lip of structure 140 may help protect the edge surface of layer 126.

If desired, the lip of structure 140 may be combined with the extension of laminate around the edge surface of layer 126. For example, as shown in FIG. 15, upper laminate 128A may wrap the edge surface of layer 126 to protect the edge surface, and the lip of structure 140 may provide additional protection.

Although cover layer 92 has been described as being coupled to shroud 100, this is merely illustrative. In some embodiments, cover layer 92 may be coupled directly to support structure 26. In other embodiments, device 10 may include a chassis attached to support structure 26 (e.g., a chassis to support various components in device 10), and cover layer 92 may be coupled to the chassis.

Moreover, although cover layer 92 has been described as including a glass layer, this material is merely illustrative. Layer 126 may be formed from ceramic, sapphire, or any other desired material.

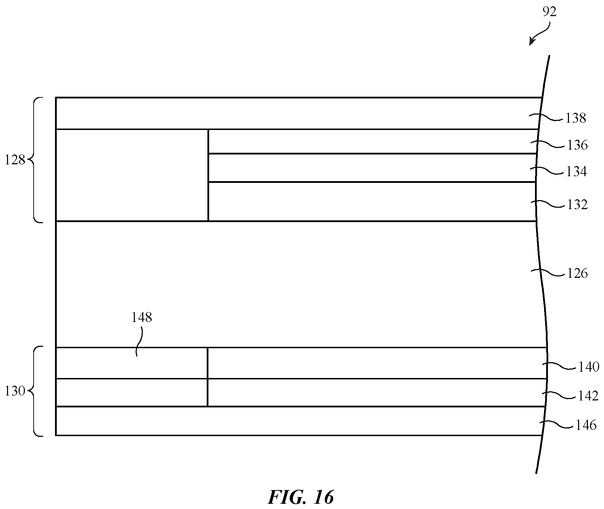

In general, laminates 128 and 130 may protect layer 126. An illustrative stackup of cover layer 92 including detailed laminates 128 and 130 is shown in FIG. 16.

As shown in FIG. 16, cover layer 92 may include layer 126, which may be glass, sapphire, or other material, and laminates 128 and 130. Although laminates 128 and 130 are shown as planar in FIG. 16 for illustrative purposes, laminate 128 may be a convex laminate, and laminate 130 may be a concave laminate (as shown in FIGS. 6-15), if desired.

Laminate 128 may include polymer layer 134 coupled to layer 126 with adhesive 132. Polymer layer 134 may be a polycarbonate (PC) layer, a polymethyl methacrylate (PMMA) layer, or other suitable polymer layer. Adhesive 132 may be a pressure-sensitive adhesive (PSA), an optically clear adhesive (OCA), or other suitable adhesive. In some illustrative embodiments, adhesive 132 may be an ultraviolet-curable OCA. Adhesive 132 may have a thickness of at least 100 microns, at least 200 microns, 150-250 microns, or other suitable thickness.

Hard coat 136 may be formed on polymer layer 134. Hard coat 136 may be an acrylic layer, a thin glass layer, a sapphire layer, or other material. In some embodiments, if polymer layer 134 is a PMMA layer, hard coat 136 may be a polycarbonate layer or a blend of polycarbonate and acrylic material. For example, hard coat 136 may be formed from an ultraviolet-curable film. Hard coat 136 may be at least 2 microns thick, three microns thick, 3-5 microns thick, or other suitable thickness.

Coating layers 138 may be formed on hard coat 136. Coating layers 138 may include an antireflection coating (e.g., a layer that matches an index of refraction of glass 126 to the air outside of glass 126) and an antismudge coating (e.g., a fluoropolymer or other oleophobic material), as examples.

By including adhesive 132 between glass 126 and polymer layer 134, polymer 134 and glass 126 may be decoupled. As a result, less stress may be applied to glass 126 from polymer 134. To reduce the amount of stress further, a UV-curable OCA may be used, as such an OCA may be soft when applied. However, this is merely illustrative. Any suitable adhesive may be used to decouple polymer 134 from glass 126 and reduce the stress applied to glass 126.

In some illustrative embodiments, polymer layer 134 may be formed from PMMA, which may match the optical properties of glass 126, particularly when cover layer 92 is curved. However, any suitable material may be used to form polymer layer 134 and match the appearance of polymer layer 134 to glass 126.

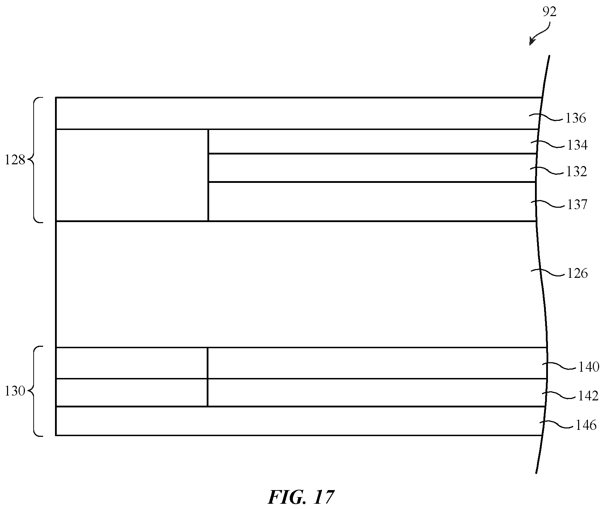

Although hard coat 136 has been described as being overlapped by coating layers 138, this is merely illustrative. In some embodiments, hard coat 136 may be formed as the outermost layer of cover layer 92. For example, as shown in FIG. 17, hard coat 136 may be formed as the outermost layer.

If desired, hard coat 136 may include antismudge properties. For example, hard coat 136 may have fluoropolymer or other oleophobic material incorporated into the hard coat material. Additionally, if an antireflection coating is desired, antireflection coating 137 may be formed as the lowermost layer of laminate 128, directly on glass 126.

Returning to FIG. 16, laminate 130 may include adhesive 140 that couples polymer 142 to glass 126. Adhesive 140 and polymer 142 may correspond with adhesive 132 and polymer layer 132. For example, adhesive 140 may be a PSA or OCA (e.g., a UV-curable OCA), and polymer layer 132 may be polycarbonate or PMMA. Polymer layer 142 may be acrylic, sapphire, glass, UV-curable material, or other suitable material.

Antireflection coating 146 may be formed on polymer layer 142. Although not shown, a UV stabilizer material, such as alumina, may be formed between polymer layer 142 and antireflection coating 146. The UV stabilizer material may have a thickness of at least 10 nm, at least 20 nm, or other suitable thickness, and may stabilize the surrounding layers when adhesives 140 and 132, and/or polymer layers 134 and 142 are cured.

Laminate 130 may also include ink 148. Ink 148 may be formed over an optical component in a head-mounted device, such as one of components 60, 62, 64, 66, 68, 70, 72, 74, 76, 78, and 80 of FIG. 3. In an illustrative embodiment, ink 148 may overlap a flood illuminator, and ink 148 may be an infrared-transparent-visible-light-blocking ink, such as an ink with 10% visible light transmission or less. However, this is merely illustrative. In general, ink 148 may overlap any component in a head-mounted device and may have a corresponding transmission spectrum.

Although FIGS. 16 and 17 show laminate 130 without a hard coat layer, this is merely illustrative. If desired, laminate 130 may have a hard coat layer, such as hard coat layer 136, either within laminate 130 or as an outermost layer of laminate 130.

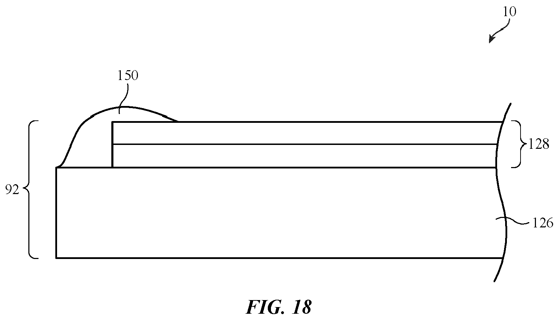

An edge seal, such as the seals of FIGS. 6-9, may protect one or more layers of laminate 128 and/or laminate 130. An illustrative example of a seal overlapping the edges of layers in laminate 128 is shown in FIG. 18.

As shown in FIG. 18, seal 150 may overlap the edges of laminate 128. In particular, seal 150 may overlap and bond to a PMMA layer, a polycarbonate layer, and/or a hard coat layer in laminate 128. In some embodiments, seal 150 may form chemical bonds with an upper surface of laminate 128. Moreover, in the illustrative example of FIG. 18, seal 150 may extend to glass layer 126. Seal 150 may be formed from polyurethane, epoxy, acrylate, PVB, or other suitable material to protect the edges of laminate 128.

As described above, one aspect of the present technology is the gathering and use of information such as information from input-output devices. The present disclosure contemplates that in some instances, data may be gathered that includes personal information data that uniquely identifies or can be used to contact or locate a specific person. Such personal information data can include demographic data, location-based data, telephone numbers, email addresses, twitter ID's, home addresses, data or records relating to a user's health or level of fitness (e.g., vital signs measurements, medication information, exercise information), date of birth, username, password, biometric information, or any other identifying or personal information.

The present disclosure recognizes that the use of such personal information, in the present technology, can be used to the benefit of users. For example, the personal information data can be used to deliver targeted content that is of greater interest to the user. Accordingly, use of such personal information data enables users to have control of the delivered content. Further, other uses for personal information data that benefit the user are also contemplated by the present disclosure. For instance, health and fitness data may be used to provide insights into a user's general wellness, or may be used as positive feedback to individuals using technology to pursue wellness goals.

The present disclosure contemplates that the entities responsible for the collection, analysis, disclosure, transfer, storage, or other use of such personal information data will comply with well-established privacy policies and/or privacy practices. In particular, such entities should implement and consistently use privacy policies and practices that are generally recognized as meeting or exceeding industry or governmental requirements for maintaining personal information data private and secure. Such policies should be easily accessible by users, and should be updated as the collection and/or use of data changes. Personal information from users should be collected for legitimate and reasonable uses of the entity and not shared or sold outside of those legitimate uses. Further, such collection/sharing should occur after receiving the informed consent of the users. Additionally, such entities should consider taking any needed steps for safeguarding and securing access to such personal information data and ensuring that others with access to the personal information data adhere to their privacy policies and procedures. Further, such entities can subject themselves to evaluation by third parties to certify their adherence to widely accepted privacy policies and practices. In addition, policies and practices should be adapted for the particular types of personal information data being collected and/or accessed and adapted to applicable laws and standards, including jurisdiction-specific considerations. For instance, in the United States, collection of or access to certain health data may be governed by federal and/or state laws, such as the Health Insurance Portability and Accountability Act (HIPAA), whereas health data in other countries may be subject to other regulations and policies and should be handled accordingly. Hence different privacy practices should be maintained for different personal data types in each country.

Despite the foregoing, the present disclosure also contemplates embodiments in which users selectively block the use of, or access to, personal information data. That is, the present disclosure contemplates that hardware and/or software elements can be provided to prevent or block access to such personal information data. For example, the present technology can be configured to allow users to select to "opt in" or "opt out" of participation in the collection of personal information data during registration for services or anytime thereafter. In another example, users can select not to provide certain types of user data. In yet another example, users can select to limit the length of time user-specific data is maintained. In addition to providing "opt in" and "opt out" options, the present disclosure contemplates providing notifications relating to the access or use of personal information. For instance, a user may be notified upon downloading an application ("app") that their personal information data will be accessed and then reminded again just before personal information data is accessed by the app.

Moreover, it is the intent of the present disclosure that personal information data should be managed and handled in a way to minimize risks of unintentional or unauthorized access or use. Risk can be minimized by limiting the collection of data and deleting data once it is no longer needed. In addition, and when applicable, including in certain health related applications, data de-identification can be used to protect a user's privacy. De-identification may be facilitated, when appropriate, by removing specific identifiers (e.g., date of birth, etc.), controlling the amount or specificity of data stored (e.g., collecting location data at a city level rather than at an address level), controlling how data is stored (e.g., aggregating data across users), and/or other methods.

Therefore, although the present disclosure broadly covers use of information that may include personal information data to implement one or more various disclosed embodiments, the present disclosure also contemplates that the various embodiments can also be implemented without the need for accessing personal information data. That is, the various embodiments of the present technology are not rendered inoperable due to the lack of all or a portion of such personal information data.

A physical environment refers to a physical world that people can sense and/or interact with without aid of electronic systems. Physical environments, such as a physical park, include physical articles, such as physical trees, physical buildings, and physical people. People can directly sense and/or interact with the physical environment, such as through sight, touch, hearing, taste, and smell.

In contrast, a computer-generated reality (CGR) environment refers to a wholly or partially simulated environment that people sense and/or interact with *via* an electronic system (e.g., an electronic system including the display systems described herein). In CGR, a subset of a person's physical motions, or representations thereof, are tracked, and, in response, one or more characteristics of one or more virtual objects simulated in the CGR environment are adjusted in a manner that comports with at least one law of physics. For example, a CGR system may detect a person's head turning and, in response, adjust graphical content and an acoustic field presented to the person in a manner similar to how such views and sounds would change in a physical environment. In some situations (e.g., for accessibility reasons), adjustments to characteristic(s) of virtual object(s) in a CGR environment may be made in response to representations of physical motions (e.g., vocal commands).

A person may sense and/or interact with a CGR object using any one of their senses, including sight, sound, touch, taste, and smell. For example, a person may sense and/or interact with audio objects that create 3D or spatial audio environment that provides the perception of point audio sources in 3D space. In another example, audio objects may enable audio transparency, which selectively incorporates ambient sounds from the physical environment with or without computer-generated audio. In some CGR environments, a person may sense and/or interact only with audio objects. Examples of CGR include virtual reality and mixed reality.

A virtual reality (VR) environment refers to a simulated environment that is designed to be based entirely on computer-generated sensory inputs for one or more senses. A VR environment comprises a plurality of virtual objects with which a person may sense and/or interact. For example, computer-generated imagery of trees, buildings, and avatars representing people are examples of virtual objects. A person may sense and/or interact with virtual objects in the VR environment through a simulation of the person's presence within the computer-generated environment, and/or through a simulation of a subset of the person's physical movements within the computer-generated environment.

In contrast to a VR environment, which is designed to be based entirely on computer-generated sensory inputs, a mixed reality (MR) environment refers to a simulated environment that is designed to incorporate sensory inputs from the physical environment, or a representation thereof, in addition to including computer-generated sensory inputs (e.g., virtual objects). On a virtuality continuum, a mixed reality environment is anywhere between, but not including, a wholly physical environment at one end and virtual reality environment at the other end.

In some MR environments, computer-generated sensory inputs may respond to changes in sensory inputs from the physical environment. Also, some electronic systems for presenting an MR environment may track location and/or orientation with respect to the physical environment to enable virtual objects to interact with real objects (that is, physical articles from the physical environment or representations thereof). For example, a system may account for movements so that a virtual tree appears stationery with respect to the physical ground. Examples of mixed realities include augmented reality and augmented virtuality.

An augmented reality (AR) environment refers to a simulated environment in which one or more virtual objects are superimposed over a physical environment, or a representation thereof. For example, an electronic system for presenting an AR environment may have a transparent or translucent display through which a person may directly view the physical environment. The system may be configured to present virtual objects on the transparent or translucent display, so that a person, using the system, perceives the virtual objects superimposed over the physical environment. Alternatively, a system may have an opaque display and one or more imaging sensors that capture images or video of the physical environment, which are representations of the physical environment. The system composites the images or video with virtual objects, and presents the composition on the opaque display. A person, using the system, indirectly views the physical environment by way of the images or video of the physical environment, and perceives the virtual objects superimposed over the physical environment. As used herein, a video of the physical environment shown on an opaque display is called "pass-through video," meaning a system uses one or more image sensor(s) to capture images of the physical environment, and uses those images in presenting the AR environment on the opaque display. Further alternatively, a system may have a projection system that projects virtual objects into the physical environment, for example, as a hologram or on a physical surface, so that a person, using the system, perceives the virtual objects superimposed over the physical environment.

An augmented reality environment also refers to a simulated environment in which a representation of a physical environment is transformed by computer-generated sensory information. For example, in providing pass-through video, a system may transform one or more sensor images to impose a select perspective (e.g., viewpoint) different than the perspective captured by the imaging sensors. As another example, a representation of a physical environment may be transformed by graphically modifying (e.g., enlarging) portions thereof, such that the modified portion may be representative but not photorealistic versions of the originally captured images. As a further example, a representation of a physical environment may be transformed by graphically eliminating or obfuscating portions thereof.

An augmented virtuality (AV) environment refers to a simulated environment in which a virtual or computer generated environment incorporates one or more sensory inputs from the physical environment. The sensory inputs may be representations of one or more characteristics of the physical environment. For example, an AV park may have virtual trees and virtual buildings, but people with faces photorealistically reproduced from images taken of physical people. As another example, a virtual object may adopt a shape or color of a physical article imaged by one or more imaging sensors. As a further example, a virtual object may adopt shadows consistent with the position of the sun in the physical environment.

There are many different types of electronic systems that enable a person to sense and/or interact with various CGR environments. Examples include head mounted systems, projection-based systems, heads-up displays (HUDs), vehicle windshields having integrated display capability, windows having integrated display capability, displays formed as lenses designed to be placed on a person's eyes (e.g., similar to contact lenses), headphones/earphones, speaker arrays, input systems (e.g., wearable or handheld controllers with or without haptic feedback), smartphones, tablets, and desktop/laptop computers. A head mounted system may have one or more speaker(s) and an integrated opaque display. Alternatively, a head mounted system may be configured to accept an external opaque display (e.g., a smartphone). The head mounted system may incorporate one or more imaging sensors to capture images or video of the physical environment, and/or one or more microphones to capture audio of the physical environment. Rather than an opaque display, a head mounted system may have a transparent or translucent display. The transparent or translucent display may have a medium through which light representative of images is directed to a person's eyes. The display may utilize digital light projection, OLEDs, LEDs, uLEDs, liquid crystal on silicon, laser scanning light source, or any combination of these technologies. The medium may be an optical waveguide, a hologram medium, an optical combiner, an optical reflector, or any combination thereof. In one embodiment, the transparent or translucent display may be configured to become opaque selectively. Projection-based systems may employ retinal projection technology that projects graphical images onto a person's retina. Projection systems also may be configured to project virtual objects into the physical environment, for example, as a hologram or on a physical surface. The display systems described herein may be used for these types of systems and for any other desired display arrangements.

According to an aspect of the invention, a head-mounted device having a front and a rear and having an interior and an exterior is provided that includes a head-mounted device housing, an optical component, a cover layer that overlaps the head-mounted device housing and the optical component, the cover layer has a first surface facing the front, a second surface facing the rear, and an edge surface and encapsulation material that separates the edge surface of the cover layer from the exterior.

Preferably, the encapsulation material includes an epoxy material on the edge surface.

Preferably, the cover layer includes a laminate on the first surface, and the encapsulation material completely covers the edge surface of the cover layer and covers an edge portion of the laminate.

Preferably, the encapsulation material includes a bumper ring between the edge surface of the cover layer and the head-mounted device housing.

Preferably, the cover layer includes a first laminate on the first surface and a second laminate on the second surface.

Preferably, the encapsulation material includes a portion of the first laminate that extends over the edge surface of the cover layer.

Preferably, the encapsulation material includes a portion of the second laminate that extends over the edge surface of the cover layer.

Preferably, the second laminate includes an additional portion that extends over a portion of the first laminate.

Preferably, the encapsulation material includes glue that fills a gap between the edge surface of the cover layer and the head-mounted housing.

Preferably, the encapsulation material includes a portion of the first laminate that covers a gap between the edge surface to and the head-mounted housing.

Preferably, the encapsulation material includes an overmold structure that contacts the edge surface and a portion of the first surface of the cover layer.

Preferably, the overmold structure is overmolded on the cover layer.

Preferably, the overmold structure is overmolded on the head-mounted housing.

Preferably, the head-mounted housing includes a shroud between the cover layer and the optical component, and the overmold structure is overmolded on the shroud.

Preferably, the encapsulation material includes a lip structure that extends over a portion of the first surface of the cover layer.

Preferably, the lip structure is a portion of the head-mounted housing.

Preferably, the head-mounted housing includes a shroud between the cover layer and the optical component, and the lip is a portion of the shroud.

Preferably, the cover layer includes a laminate on the first surface, and the encapsulation material further includes a portion of the laminate that extends over the edge surface of the cover layer.

According to an aspect of the invention, a head-mounted device is provided that includes a head-mounted device housing, an optical component, a cover layer that overlaps the head-mounted device housing and the optical component, the cover layer has opposing first and second surfaces and an edge surface that extends between the first and second surfaces and an edge seal on the edge surface, the edge seal is interposed between the edge surface and the head-mounted device housing.

Preferably, the cover layer includes a laminate on the first surface of the cover layer.

Preferably, the cover layer further includes a glass layer, the laminate includes a polymer layer coupled to the glass layer with an ultraviolet-curable adhesive, and a hard coat on the polymer layer.

Preferably, the hard coat forms an outermost layer of the laminate.

Preferably, the hard coat includes antismudge material.

Preferably, the polymer layer includes polymethyl methacrylate, and the hard coat includes acrylic.

Preferably, the edge seal overlaps an edge of the hard coat and the polymer layer.

Preferably, the laminate overlaps the edge seal.

Preferably, a portion of the edge seal is in contact with the laminate.

Preferably, the edge seal includes a ductile epoxy.

According to an aspect of the invention, a portable electronic device having a front and a rear is provided that includes a housing, an optical component in the housing, a cover layer that overlaps the optical component, the cover layer has a first surface that faces the front, an opposing second surface, and an edge surface that extends between the first and second surfaces, a shroud that is interposed between the second surface and the optical component and encapsulation material attached to the edge surface.

Preferably, the encapsulation material includes epoxy.

Preferably, the encapsulation material includes glue that fills a gap between the edge surface and the shroud.

Preferably, the encapsulation material includes an overmolded portion of the housing or the shroud.

Preferably, the encapsulation material includes a bumper ring.

The foregoing is merely illustrative and various modifications can be made to the described embodiments. The foregoing embodiments may be implemented individually or in any combination.

## Claims

1. A head-mounted device having a front and a rear and having an interior and an exterior, comprising:
a head-mounted device housing;
an optical component;
a cover layer that overlaps the head-mounted device housing and the optical component, wherein the cover layer has a first surface facing the front, a second surface facing the rear, and an edge surface; and
encapsulation material that separates the edge surface of the cover layer from the exterior.

2. The head-mounted device of claim 1, wherein the encapsulation material comprises an epoxy material on the edge surface, the cover layer includes a laminate on the first surface, and the encapsulation material completely covers the edge surface of the cover layer and covers an edge portion of the laminate.

3. The head-mounted device of either of claims 1 or 2, wherein the encapsulation material comprises a bumper ring between the edge surface of the cover layer and the head-mounted device housing.

4. The head-mounted device of claim 1, wherein the cover layer includes a first laminate on the first surface and a second laminate on the second surface.

5. The head-mounted device of claim 4, wherein the encapsulation material comprises a portion of the first laminate that extends over the edge surface of the cover layer.

6. The head-mounted device of either of claims 4 or 5, wherein the encapsulation material comprises a portion of the second laminate that extends over the edge surface of the cover layer, and the second laminate comprises an additional portion that extends over a portion of the first laminate.

7. The head-mounted device of any of claims 4 to 6, wherein the encapsulation material comprises a portion of the first laminate that covers a gap between the edge surface and the head-mounted housing.

8. The head-mounted device of any preceding claim, wherein the encapsulation material comprises glue that fills a gap between the edge surface of the cover layer and the head-mounted housing.

9. The head-mounted device of any preceding claim, wherein the encapsulation material comprises an overmold structure that contacts the edge surface and a portion of the first surface of the cover layer.

10. The head-mounted device of claim 9, wherein the overmold structure is overmolded on the head-mounted housing, the head-mounted housing comprises a shroud between the cover layer and the optical component, and the overmold structure is overmolded on the shroud.

11. The head-mounted device of claim 1, wherein the encapsulation material comprises a lip structure that extends over a portion of the first surface of the cover layer.

12. The head-mounted device of claim 11, wherein the lip structure is a portion of the head-mounted housing, and the head-mounted housing comprises a shroud between the cover layer and the optical component, and wherein the lip is a portion of the shroud.

13. The head-mounted device of either of claims 11 or 12, wherein the cover layer comprises a laminate on the first surface, and wherein the encapsulation material further comprises a portion of the laminate that extends over the edge surface of the cover layer.

14. The head-mounted device of claim 1, wherein the cover layer includes a laminate on the first surface of the cover layer and a glass layer, the laminate comprises a polymer layer coupled to the glass layer with an ultraviolet-curable adhesive and a hard coat on the polymer layer.

15. The head-mounted device of claim 14, wherein the hard coat forms an outermost layer of the laminate, the hard coat comprises anti smudge material, the polymer layer comprises polymethyl methacrylate, and the hard coat comprises acrylic.
